# EUROPÄISCHE PATENTSCHRIFT

(11) **EP 0 438 694 B1**
(45) Veröffentlichungstag und Bekanntmachung des Hinweises auf die Patenterteilung: **30.08.1995**
(21) Anmeldenummer: 90123840.2
(22) Anmeldetag: 11.12.1990
(51) Int. Cl.: H03J 7/18

(54) **Verfahren und Anordnung zur Programmspeicherung in Fernsehempfangsgeräten**
Method and device for the storage of programmes in a television receiver
Procédé et montage pour la mise en mémoire de programmes pour récepteur de télévision

(30) Priorität: 15.12.1989 DE 3941628
(43) Veröffentlichungstag der Anmeldung: 31.07.1991
(73) Patentinhaber: Bosch-Siemens Hausgeräte GmbH, 81669 München (DE)
(72) Erfinder: Lerch, Dietmar, W-8060 Dachau (DE); Nickel, Rüdiger, 8032 Gräfelfing/Lochham (DE)

(56) Entgegenhaltungen:
- EP-A- 0 050 328
- EP-A- 0 072 943
- PATENT ABSTRACTS OF JAPAN, Band 14, Nr. 51 (E-881), 30. Januar 1990;& JP-A-1 276 914

## Beschreibung

Die Erfindung betrifft ein Verfahren und eine Anordnung zur Programmspeicherung in Fernsehempfangsgeräten nach dem Oberbegriff des Patentanspruchs 1.

Aus der DE-PS 31 45 407 ist bereits eine Einrichtung zum automatischen Programmieren eines Stationsspeichers und zum Voreinstellen eines von dem Stationsspeicher steuerbaren Fernsehempfangs-Tuners bekannt, wobei davon ausgegangen wird, daß in Fernsehsignale senderseitig codierte Zusatzinformationen über sämtliche, dem jeweiligen Sender im zeitlichen Wechsel zugeordnete Programmquellen (beispielsweise "ARD" (= Erstes Fernsehprogramm der BR Deutschland), "ZDF"(Zweites Deutsches Fernsehen)) zugesetzt wird.
Bei der bekannten Einrichtung werden bei Auftreten von Fernsehsendersignalen mit gleicher Kennung in Form eines im Fernsehsendersignal enthaltenen Kennungssignals aber unterschiedlicher Empfangsfeldstärke fernsehsenderindividuelle Informationen des Signals größter Feldstärke in einen Stationsspeicher abgespeichert, während fernsehsenderindividuelle Informationen kennungsgleicher Fernsehsignale geringerer Feldstärke nicht abgespeichert werden. Damit läßt sich bei der bekannten Einrichtung ein Fernsehempfangsgerät auf das Fernsehsignal größter Feldstärke einstellen. Bei einem temporären Ausfall des betreffenden Fernsehsenders läßt die bekannte Einrichtung dagegen eine Umschaltung auf einen möglicherweise vorhandenen störungsfreien kennungsgleichen Sender ohne weiteres nicht zu. Vielmehr hätte eine Bedienperson des Fernsehempfangsgeräts einen neuen Sendersuchlauf zu starten, um das Gerät auf einen möglicherweise vorhandenen störungsfreien kennungsgleichen Sender einzuschalten.

Der Erfindung liegt demgegenüber die Aufgabe zugrunde, ein Verfahren der eingangs genannten Art in der Weise auszubilden, daß Fernsehgeräte bei Ausfall eines Fernsehsenders auf einen Sender gleicher Kennung selbsttätig umschalten.

Die Lösung dieser Aufgabe erfolgt erfindungsgemäß durch die kennzeichnenden Merkmale des Patentanspruchs 1.

Hierdurch ergibt sich der Vorteil, daß in einem Fernsehempfangsgerät bei Ausfall eines Fernsehsenders Fernsehsignale eines anderen Senders gleicher Kennung zur bildlichen und akustischen Darstellung umgesetzt werden. Eine Umschaltung von einem Sender auf einen anderen Sender gleicher Kennung durch eine Bedienperson erübrigt sich damit.
Dieser Vorteil ist besonders bei einem Videoaufzeichnungsgerät ausgeprägt, wenn während einer Aufzeichnung das entsprechende Fernsehsendersignal ausfällt und ein kennungssignalgleiches Fernsehsendersignal zur Verfügung steht. Das Verfahren gemäß der Erfindung ermöglicht in diesem Fall die praktisch störungsfreie Aufzeichnung einer Fernsehsendung.

Nach einer weiteren vorteilhaften Ausführungsform werden Stationstasten, die im Normalbetrieb, also wenn Fersehsendersignale mit der üblichen Empfangsfeldstärke empfangen werden, ersten kennungssignalindividuellen Speichern zugeordnet sind, zweiten kennungssignalindividuellen Speichern zugeordnet. Durch Betätigung der gleichen Stationstaste wird, selbst wenn ein Fernsehsendersignal relativ großer Empfangsfeldstärke ausfällt, das Fernsehempfangsgerät auf ein Signal gleicher Kennung eingestellt.

Nach weiteren vorteilhaften Ausführungsformen werden fernsehsenderindividuelle Informationen von Fernsehsendern ohne Kennungssignal abgespeichert und entspechend ihrer Empfangsfeldstärke Stationstasten zugeordnet. Darüber hinaus lassen sich nach weiteren vorteilhaften Ausführungsformen der Erfindung benutzerindividuelle Zuordnungen von Senderfrequenzen und Speicherplätzen bzw. Stationstasten realisieren.

Die Erfindung geht davon aus, daß an dem Empfangsort eines Fernsehgeräts Fernsehsendersignale empfangen werden, die jeweils ein eine bestimmte Programmquelle (beispielsweise ARD, ZDF usw. ) bezeichnendes Kennungssignal Kx umfassen. Ein solches Kennungssignal kann beispielsweise in einem Farbfernsehsignal enthalten sein, insbesondere im einem Bi-phase-Code modulierten Datenblock in Zeile 329 einer 625-Zeilennorm, bzw. in Teletextdaten (Videotextdaten), die gemeinsam mit einem Fernsehsignal übertragen werden.

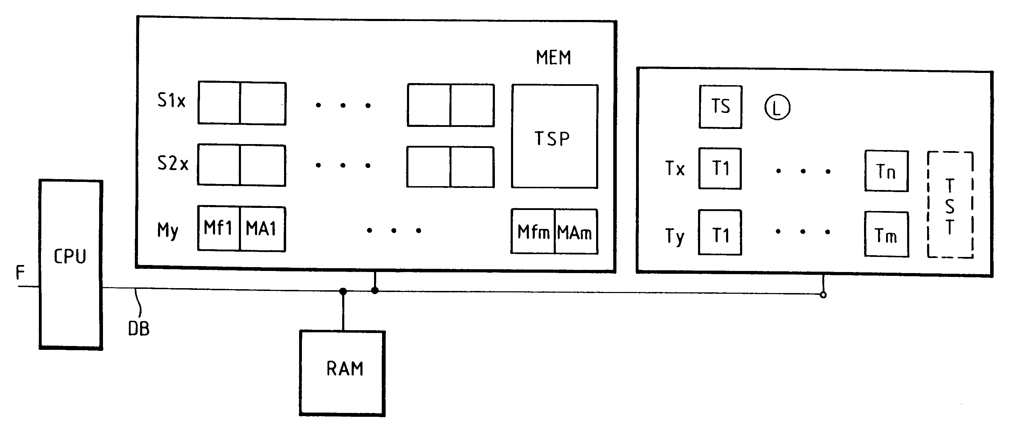

Die Erfindung wird nun anhand einer Figur beschrieben. Die Figur zeigt das Blockschaltbild einer erfindungsgemäßen Anordnung zur Programmspeicherung in Fernsehempfangsgeräten.

Ein Fernsehempfangsgerät F enthält eine Steuerung CPU, die über einen Datenbus DB mit einem Betriebsprogramm-Speicher RAM und mit einem Arbeitsspeicher MEM, mit Stationstasten Tx (x = 1 ... n) sowie mit einer Sondertaste TS und einer dieser zugeordneten Leuchtdiode L verbunden ist.

Der Arbeitsspeicher MEM, der als nichtflüchtiger Speicher ausgebildet ist, umfaßt erste und zweite kennungssignalindividuelle Speicher S1x, S2x sowie einen Speicher TSP zur Speicherung einer Tabelle. Die Speicher S1x, S2x sind durch Fernsehsender-Kennungssignale Kx bezeichnende Adressdaten K′x adressierbar.

Nach einer weiteren Ausführungsform der Erfindung umfaßt der Arbeitsspeicher MEM auch nichtkennungssignalindividuelle Speicher My (y = 1 ... m). Die Anordnung gemäß der Erfindung weist dann weitere Tasten Ty auf, die den Speichern My zugeordnet sind.

Die Speicher S1x, S2x und My weisen vorzugsweise paarweise miteinander verknüpfte Speicherplätze auf, in denen fernsehsenderindividuelle Informationen abgespeichert werden, insbesondere Informationen, die die Senderfrequenz und die Empfangsfeldstärke der im Rahmen eines Sendersuchlaufs detektierten Fernsehsendersignale bezeichnen.
Die Speicher S1x, S2x sind durch die Fernsehsender-Kennungssignale Kx bezeichnende Informationen K′x adressierbar.

Den Stationstasten Tx sind den ersten kennungssignalindividuellen Speichern S1x fest zugeordnet; erfindungsgemäß wird bei Ausfall der Empfangsfeldstärke eines Senders mit einer bestimmten Kennung die Stationstaste,beispielsweise T4, die im Normalbetriebsfall einem ersten kennnungssignalindividuellen Speicher S1x, beispielsweise S14, zugeordnet ist, dem entsprechenden zweiten kennungssignalindividuellen Speicher S24 zugeordnet.

Demgegenüber sind die Stationstasten Ty den nichtkennungssignalindividuellen Speicher My zugeordnet.

Die Tastatur kann eine eigene Teilsteuerung TST aufweisen, die die eigentlichen Tastenfuntionen steuert und insoweit die Steuerung CPU entlastet.
Die Tasten Tx, Ty, TS können in einem Fernbedienungsgeber angeordnet sein und mit der Steuerung CPU drahtlos über in der Figur nicht dargestellte Sende- und Empfangseinrichtungungen beziehungsweise über eine nicht dargestellte Verbindungsleitung verbunden sein.

Nicht in der Figur dargestellt sind die für sich bekannten Einrichtungen des Fernsehempfangsgeräts zur Durchführung des Sendersuchlaufs, der Detektion von Fernsehsenderfrequenzen f1 ... fn, Fernsehsenderfeldstärken A1 ... An und Kennungssignale K1 ... Kn sowie zur Bildung entsprechender Informationen f′1 ...f′n; A′1 ... A′n, K′1 ... K′n in vorzugsweise digitaler Darstellung.

Die erfindungsgemäßen Steuerungsoperationen, die durch das im Speicher RAM abgelegte Betriebsprogramm definiert sind, werden im folgenden beschrieben.

Ausgelöst durch ein Einschalten des Fernsehgeräts F, inbesondere aber durch einen separaten Startbefehl, der beispielsweise auch durch Betätigung der Sondertaste TS erzeugt werden kann, initiiert die Steuerung CPU einen Sendersuchlauf und detektiert dabei mittels entsprechender Einrichtungen Fernsehsenderfrequenzen fx und die zugehörigen Feldstärkewerte Ax (x = 1 ... n). Soweit ein Fernsehsendersignal auch ein Kennungssignal Kx enthält, wird auch dieses detektiert.
Die Steuerung CPU veranlaßt die entsprechenden Einrichtungen zur Bildung bzw. Codierung entsprechender Informationen f′x, A′x, K′x in vorzugsweise digitaler Darstellung.

Nach der Detektion eines Fernsehsignals und der Bildung der Informationen f′x, A′x und, sofern das Fernsehsignal ein Kennungssignal Kx enthält, von K′x prüft die Steuerung CPU, ob bereits eine übereinstimmende Kennungssignalinformation K′x in einem Speicher S1x abgespeichert worden ist. Für diese Prüfung kann die Steuerung CPU, wie noch erläutert wird, auf den Tabellenspeicher TSP zurückgreifen.
Wurde noch keine übereinstimmende Kennungssignalinformation K′x in einen Speicher S1x abgespeichert, speichert die Steuerung die Kennungssignalinformation K′x des gerade empfangenen Fernsehsignals und die zugehörigen Informationen f′x, A′x in einen Speicher S1x ab. Dies kann ein beliebiger Speicher S1x sein oder ein für diese Kennungssignalinformation K′x reservierter Speicher S1x. Eine solche Reservierung setzt voraus, daß die für den Empfangsort des Fernsehempfangsgeräts in Betracht kommenden Kennungssignalinformationen vor der Erstinbetriebnahme der erfindungsgemäßen Anordnung in den Tabellenspeicher TSP eingegeben werden.

Wurde dagegen bereits eine mit der Kennungssignalinformation K′x übereinstimmende Kennungssignalinformation in einen Speicher S1x abgespeichert, prüft die Steuerung CPU, ob die dort ebenfalls abgespeicherte Information A′x auf eine größere Empfangsfeldstärke Ax hinweist als die Information A′x des gerade empfangenen Fernsehsignals.
Bei einem positiven Ergebnis dieser Prüfung speichert die Steuerung CPU die Informationen f′x und A′x des gerade empfangenen Signals in den Speicher S1x ein, in dem zuvor die Informationen f′x und A′x des kennungssignalgleichen Fernsehsignals geringerer Empfangsfeldstärke abgespeichert waren. Diese letztgenannten Informationen f′x und A′x des kennungssignalgleichen Fernsehsignals geringerer Empfangsfeldstärke werden, gegebenenfalls zusammen mit der zugehörigen Information K′x von der Steuerung CPU in einen Speicher S2x übertragen. Dies kann wiederum ein beliebiger Speicher S2x oder ein für diese Kennungssignalinformation K′x reservierter Speicher S2x sein. Soweit in den Tabellenspeicher TSP vor Inbetriebnahme keine kennungssignalindividuelle Adressen der Speicher S1x und S2x eingeben werden, damit also die Informationen f′x, A′x und K′x in beliebige Speicher S1x und S2x abgespeichert werden, sind im Zusammenhang mit dieser Abspeicherung für jedes Fernsehsignal gleicher Kennung die Adressen derjenigen Speicher S1x und S2x in den Tabellenspeicher TSP einzuschreiben, in die die zugehörigen Informationen f′x und A′x abgespeichert werden.

In dem Tabellenspeicher TSP können verschiedene Zuordnungen fest vorgegeben sein. Sofern die - länderspezifischen- Kennungssignalinformationen K′x vor Inbetriebnahme der erfindungsgemäßen Anordnung bekannt sind, können diese in den Tabellenspeicher TSP eingegeben werden und für Jede Kennungssignalinformation K′x können die Adressen der Speicher S1x, S2x und eine Stationstaste Tx fest vorgegeben sein. In diesem Fall, wenn also die Zuordnungen K′x, Adressen S1x, S2x und Tx fest vorgegeben sind, ist in den Tabellenspeicher TSP für jedes detektierte Fernsehsignal lediglich eine Information darüber einzuschreiben, daß ein Informationspaar f′xA′x in den dem betreffenden Kennungssignal entsprechenden Speicher S1x und gegebenenfalls in den entsprechenden Speicher S2x abgespeichert wurde.

Sofern die Kennungssignalinformationen nicht vor der Inbetriebnahme der erfindungsgemäßen Anordnung in den Tabellenspeicher TSP eingegeben werden, kann eine feste Zuordnung der Adressen der Speicher S1x und S2x sowie von Stationstasten Tx, mindestens jedoch eine feste Zuordnung der Adressen der Speicher S1x und der Stationstasten Tx vorgegeben werden.
Nach Abschluß eines Sendersuchlaufs und der dabei durchgeführten Prüfungen und Abspeicherungen enthält der Tabellenspeicher TSP für jedes detektierte Kennungssignal Kx eine Zuordnung K′x, Adressen der Speicher S1x, S2x und Stationstaste Tx.

Bei dem erfindungsgemäßen Verfahren vergleicht also die Steuerung bei Auftreten eines zweiten Fernsehsendersignal mit gleichem Kennungssignal die Empfangsfeldstärkewerte der betreffenden Fersehsendersignale miteinander und überschreibt, sofern der Feldstärkewert des hinzugekommenen Fernsehsendersignals größer als der abgespeicherte Feldstärkewert ist, das in dem ersten kennungssignalindividuellen Speicher S1x abespeicherte Informationspaar (f′xA′x) mit dem dem hinzugekommenen Fersehsendersignal grösserer Feldstärke entsprechenden Informationspaar (f′xA′x). Außerdem überträgt die Steuerung CPU das bisher in dem ersten kennungssignalindividuellen Speicher S1x abgespeicherte Informationspaar (f′xA′x) in einen zweiten kennungssignalindividuellen Speicher S2x. Sofern aber die Feldstärke des hinzugekommenen Fernsehsignals gleich oder kleiner als der abgespeicherte Feldstärkewert ist, wird das dem hinzugekommenen Fernsehsignal entsprechende Informationspaar (f′xA′x) in den zweiten kennungssignalindividuellen Speicher S2x abgespeichert.

Der Umfang der erforderlichen Adressenspeicherung der Speicher S1x, S2x ergibt sich aus der vor der Inbetriebnahme der erfindungsgemäßen Anordnung im Tabellenspeicher TSP voreingestellten Zuordnung:
wenn lediglich die Zuordnung zwischen den ersten Speichern S1x und den Stationstasten Tx vorgegeben ist, sind im Zusammenhang mit dem Sendersuchlauf für jedes Kennungssignal die gebildete Information K′x sowie die Adresse des zugehörigen Speichers S1x in den Tabellenspeicher TSP einzuschreiben; bei Auftreten eines kennungsgleichen Signals auch die Adresse des zugehörigen Speichers S2x.

Bei einem Sendersuchlauf können auch mehr als zwei kennungsgleiche Fernsehsendersignale erkannt werden. Tritt beispielsweise ein drittes Signal gleicher Kennung auf, wird dessen Feldstärkewert A′x mit den bereits in den Speichern S1x und S2x abgespeicherten Feldstärkewerten A′x verglichen. Erfindungsgemäß werden die Informationspaare f′xA′x der beiden Signale mit den größten Empfangsfeldstärkewerten in den Speichern S1x und S2x abgespeichert, während das Informationspaar f′xA′x des Signals mit der geringsten Empfangsfeldstärke nicht abgespeichert wird. Alternativ hierzu können auch dritte kennungssignalindividuelle Speicher S3x vorgesehen sein.

Der Ausfall eines Fernsehsignals (Empfangsfeldstärke geht auf den Wert Null), insbesondere des Fernsehsignals, auf das das Fernsehempfangsgerät im Betrieb abgestimmt ist, kann durch einen separaten Sensor oder durch die Sendersuchlaufeinrichtung erkannt werden. Die Sendersuchlaufeinrichtung ist hierzu in der Weise ausgebildet, daß sie eingestellt auf die Empfangsfrequenz Änderungen der Empfangsfeldstärke registriert, und, sofern diese den Wert Null annimmt, ein Signal an die Steuerung CPU abgibt. Dieses Signal wird der Steuerung CPU beispielsweise während der gesamten Zeit zugeführt, zu der die Empfangsfeldstärke den Wert Null hat. Alternativ hierzu wird das Signal, das den Ausfall der Empfangsfeldstärke anzeigt, nur in Form eines kurzen Impulses erzeugt, wobei zusätzlich ein zweites Signal bei Beendigung des Ausfalls erzeugt wird.

Ausgelöst durch das Ausfallsignal überprüft die Steuerung CPU, ob in einem zweiten Speicher S2x ein Informationspaar f′xA′x für ein kennungsgleiches Signal abgespeichert ist. Sie greift hierzu auf den Tabellenspeicher TSP zu, der die Adresse des entsprechenden zweiten Speichers S2x enthält, und stellt das Fernsehempfangsgerät auf die Frequenz ein, die der in dem zweiten Speicher S2x abgespeicherten Frequenzinformation f′x entspricht.
Außerdem ordnet die Steurung CPU die Stationstaste Tx, die im Normalbetrieb dem entsprechenden Speicher S1x zugeordnet ist, dem Speicher S2x zu, der das Informationspaar f′xA′x des bezüglich des ausgefallenen Signals kennungsgleichen Signals enthält. Diese Zuordnung bleibt erhalten, bis die Steuerung CPU, ausgelöst durch das Abklingen des Ausfallsignals bzw. durch das zweite Signal, die ursprüngliche Zuordnung von Speicher S1x und Taste Tx wiederherstellt und das Fernsehempfangsgerät auf die ursprüngliche Frequenz einstellt.

Die erfindungsgemäße Anordnung kann eine eigene Spannungsquelle aufweisen und in der Weise ausgebildet sein, daß auch nach Ausschalten des Fernsehempfangsgeräts durch die Bedienperson die Empfangsfeldstärkewerte registriert und somit erkannt wird, daß das ausgefallene Fernsehsendersignal wieder den üblichen Feldstärkewert Ax annimmt.

Soweit die erfindungsgemäße Anordnung in Zeiten, in denen das Fernsehempfangsgerät ausgeschaltet ist, Empfangsfeldstärkewerte eines vor dem Ausschalten ausgefallenen Fernsehsendersignals nicht registriert und damit nicht erkennt, daß das ausgefallene Fernsehsendersignal wieder den üblichen Wert annimmt, ist vorzugsweise eine Leuchtdiode vorgesehen, die ausgelöst durch das Ausfallsignal aktiviert wird. Sie wird durch das Ausschalten zwar deaktiviert, jedoch bleibt beispielsweise ein Relais gesetzt, so daß sie bei Wiedereinschalten des Fernsehempfangsgeräts auf den vor dem Ausschalten erfolgten Ausfall des Fernsehsendersignals hinweist. Die Bedienperson wird dann, sofern ein Sendersuchlauf durch die Sondertaste TS initiiert wird, diese Taste TS betätigen und damit den Sendersuchlauf auslösen. Damit werden wie bei der Erstinbetriebnahme der erfindungsgemäßen Anordnung die Speicher S1x, S2x gegebenenfalls My programmiert, mit der Folge, daß für das ursprünglich ausgefallene Fernsehsendersignal, das seinen üblichen Empfangsfeldstärkenwert wiedereingenommen hat, wieder ein Informationspaar f′xA′x (f # 0, A # 0) gebildet wird.
Durch die anschließende Betätigung der entsprechenden Stationstaste Tx wird das Fernsehempfangsgerät wieder auf die Frequenz des ursprünglichen Fernsehsendersignals eingestellt.

Die Anordnung gemäß der Erfindung kann auch nichtkennsignalindividuelle Speicher My aufweisen. In die Speicher My werden die die Frequenz bzw. die Empfangsfeldstärke bezeichnende Informationen von Fernsehsendersignalen eingespeichert, die beim Sendersuchlauf detektiert werden und entweder kein Kennungssignal enthalten oder aber, sofern erste Speicher S1x für bestimmte Kennungssignale reserviert sind, ein Kennungssignal enthalten, für das kein erster Speicher reserviert ist. Diese Informationspaare werden im folgenden mit "f′yA′y" bezeichnet.
Die Steuerung CPU führt bei Auftreten solcher Fernsehsignale die folgenden Prozeduren durch:
Bei Auftreten dieser Fernsehsendersignale bildet die Steuerung CPU je ein die Fersehsenderfrequenz- und -empfangsfeldstärke bezeichnendes Informationspaar f′yA′y, y = 1 ... m und speichert diese Informationspaare f′yA′y in 2m paarweise miteinander verknüpfte, nach ab- oder aufsteigenden Feldstärkewerten geordnete Speicherplatzpaare MfyMAy eines nichtkennungssignalindividuellen Speichers My ab, dem die speicherplatzpaarindividuelle Stationstasten Ty zugeordnet sind. Diese Zuordnung der Tasten Ty zu den Speicherplatzpaaren MfyMAy kann in dem Tabellenspeicher TSP abgespeichert sein.

Die Steuerung CPU verteilt die Informationspaare f′yA′y der Fernsehsendersignale ohne Kennungssignal und gegebenenfalls die Informationssignale fxAx der Fernsehsendersignale mit Kennungssignal, für die keine ersten kennungssignalindividuellen Speicher S1x vorgesehen sind, in der Weise auf die Speicherplätze MfyMAy des nichtkennungssignalindividuellen Speichers My, daß in einem, einer ersten speicherplatzindividuellen Stationstaste (Ty, y=1) zugeordneten Speicherplatzpaar Mf1MA1 das der größten Feldstärke A1 entsprechende Informationspaar f′1A′1 abgespeichert wird und daß in einem zweiten, einer zweiten Stastionstaste (Ty, y = 2) zugeordneten Speicherplatzpaar Mf2MA2 das der zweitgrößten Feldstärke A2 entsprechende Informationspaar f′2A′2 und in weiteren, den weiteren Eingabetasten T3...Tn zugeordneten Speicherplatzpaaren Mf3MA3 ... MfnMAn diejenigen Informationspaare f′3A′3 ...f′mnA′m abgespeichert werden, die den weiteren Feldstärken A3...Am in abnehmender Reihenfolge ihrer Werte entsprechen.

Insbesondere speichert die Steuerung CPU nach der Bildung eines zeitlich ersten Frequenz- und Feldstärkeinformationspaars f′yA′y dieses in das dem größten Feldstärkewert(A1) zugeordneten Speicherplatzpaar Mf1MA1 ab und vergleicht nach der Bildung eines zeitlich zweiten Frequenz- und Feldstärkeinformationspaars f′yA′y den entsprechenden zweiten Feldstärkewert (A2) mit dem dem zeitlich ersten Informationspaar entsprechenden ersten Feldstärkewert (A1).
Sofern der zweite Feldstärkewert gleich dem ersten Feldstärkewert oder kleiner als dieser ist, wird das zweite Informationspaar in das dem zweitgrößten Feldstärkewert (A2) zugeordneten Speicherplatzpaar Mf2MA2 abspeichert, oder sofern der zweite Feldstärkewert größer als erste Feldstärkewert ist, wird das erste Informationspaar in das dem zweitgrößten Feldstärkewert zugeordneten Speicherplatzpaar Mf2MA2 und das zweite Informationspaar in das dem größten Feldstärkewert A1 zugeordneten Speicherplatzpaar Mf1MA1 abspeichert.
Nach Bildung jeweils eines zeitlich weiteren Informationspaars vergleicht die Steuerung CPU den jeweils entsprechenden Feldstärkewert mit den den abgespeicherten Informationspaaren entsprechenden Feldstärkewerten und verteilt die abgespeicherten Informationspaare und das jeweils zeitlich weitere Informationspaar auf die den größten Feldstärkewerten A1, A2, A3, ... zugeordneten Speicherplatzpaare Mf1MA1, Mf2MA2, Mf3MA3, ... entsprechend der Zuordnung von Stationstasten Ty, y = 1, 2, 3 ... und Feldstärkewerten A1, A2, A3, ...

Mit den beiden im folgenden beschriebenen Ausführungsformen der Erfindung lassen sich benutzerindividuelle Zuordnungen von Senderfrequenzen und Speicherpätzen bzw. Stationstasten realisieren. Beispielsweise können ausgewählten Stationstasten individuell Frequenzen von bevorzugten Sendern geringer Empfangsqualität zugeordnet werden. Auch lassen sich Frequenzen von Sendern gleicher Empfangsleistung tastenindividuell zuordnen.

Nach der ersten der beiden genannten Ausführungsformen überführt die Steuerung CPU im Anschluß an die Verteilung der gebildeten Frequenz- und Feldstärkeinformationspaare f′1A′1 ... f′mA′m auf die Speicherplatzpaaare Mf1MA1 ... MfmMAm, ausgelöst durch Betätigung der Sondertaste TS und einer ersten speicherplatzindividuellen Taste Ti das in dem zugehörigen Speicherplatzpaar MfiMAi abgespeicherte Informationspaar f′iA′i in das Speicherplatzpaar Mf1MA1, in dem ursprünglich das der größten Feldstärke A1 zugeordnete Informationspaar f′1A′1 abgespeichert war, und verteilt dieses Informationspaar f′1A′1 sowie die übrigen Informationspaare f′2A′2 ... f′i-1, f′i+1 ... f′mA′m auf die übrigen Speicherplatzpaare Mf2MA2 ... MfmMAm in abnehmender Reihenfolge der Feldstärkewerte.

Äquivalent hierzu ist eine Zuordnung der Informationspaare auf die Speicherplatzpaare in aufsteigender Reihenfolge der Feldstärkewerte.

Nach einer weiteren Ausführungsform der Erfindung vertauscht die Steuerung CPU im Anschluß an die Verteilung der gebildeten Frequenz- und Feldstärkeinformationspaare f′1A′1 ... f′1A′n auf die Speicherplatzpaare MfaMA1 ... MfmMAm ausgelöst durch Betätigung der Sondertaste TS, einer ersten speicherplatzindividuellen Stationstaste Ti und einer zweiten speicherplatzindividuellen Stationstaste Tj die in den zugehörigen Speicherplatzpaaren MfiMAi, MfjMAj abgespeicherten Informationspaare f′iA′i, f′jA′j miteinander.

Der Arbeitsspeicher MEM, insbesondere der Tabellenspeicher TSP, kann manuell auswechselbar auf der Schaltungsplatine der erfindungsgemäßen Anordnung ausgestaltet sein. Der Speicherkörper weist hierzu beispielsweise mechanisch stabile Kontaktfahnen auf, die in korrespondierende Bohrungen einführbar sind, und im eingeführten Zustand einen galvanischen Kontakt zu den übrigen Komponenten der Anordnung bilden. Damit lassen sich Arbeitsspeichermodule mit extern voreingestellten Adressdaten, die länderspezifischen Kennungssignalen entsprechen, in einfacher Weise in die Anordnung einbringen bzw. austauschen.

## Patentansprüche

1. Verfahren zur Programmspeicherung in Fernsehempfangsgeräten, wobei eine Steuerung(CPU) des Fernsehempfangsgeräts(F) bei einem Sendersuchlauf über den von dem Fernsehempfangsgerät(F) empfangbaren Fernsehsender-Frequenzbereich nacheinander Fernsehsendersignale auf diese mitumfassende Kennungssignale (Programmquellensignale Kx) überprüft, ein die Fernsehsenderfrequenz (fx, x = 1 ... n) und Fernsehsenderfeldstärke (Ax) bezeichnendes Informationspaar (f′xA′x) bildet und dieses Informationspaar (f′xA′x) in erste kennungssignalindividuelle Speicher (S1x) einspeichert, denen je eine kennungssignalindividuelle Stationstaste (Tx) zugeordnet ist, durch deren Betätigung die Steuerung (CPU) die in dem zugehörigen Speicher (S1x) abgespeicherte Frequenzinformation (f′x) abruft und das Fernsehempfangsgerät (F) auf die der abgerufenen Frequenzinformation (f′x) entsprechende Frequenz (fx) einstellt,
**dadurch gekennzeichnet**,
daß die Steuerung (CPU) im Rahmen eines Sendersuchlaufs bei Auftreten eines zweiten oder weiteren Fernsehsenders mit gleichem Kennungssignal die Feldstärkewerte der betreffenden Fernsehsendersignale miteinander vergleicht und, sofern der Feldstärkewert des hinzugekommenen Fernsehsendersignals größer als der abgespeicherte Feldstärkewert ist, das in dem ersten kennungssignalindividuellen Speicher (S1x) abgespeicherte Informationspaar mit dem dem hinzugekommenen Fernsehsendersignal grösserer Feldstärke entsprechenden Informationspaar überschreibt, und das bisher in dem ersten kennungssignalindividuellen Speicher (S1x) abgespeicherte Informationspaar in einen zweiten kennungssignalspezifischen Speicher (S2x) überträgt, oder sofern die Feldstärke des hinzugekommenen Fernsehsignals gleich oder kleiner als der abgespeicherte Feldstärkewert ist, das dem hinzugekommenen Fernsehsignal entsprechende Informationspaar in den zweiten kennungssignalindividuellen Speicher (S2x) abspeichert, daß die Steuerung (CPU) ausgelöst durch einen, den Ausfall der Empfangsfeldstärke des gerade empfangenen Fernsehsendersignals grösserer Feldstärke kennzeichnenden Befehl das Fernsehempfangsgerät (F) auf die der in dem zweiten kennungssignalindividuellen Speicher (S2x) abgespeicherte Frequenzinformation (f′x) entsprechende Frequenz (fx) des kennungssignalgleichen Fernsehsendersignals einstellt.

2. Verfahren nach Anspruch 1,
**dadurch gekennzeichnet**,
daß die Steuerung (CPU) ausgelöst durch den den Ausfall der Empfangsfeldstärke des gerade empfangenen Fernsehsendersignals grösserer Feldstärke kennzeichnenden Befehl die Stationstaste (Tx), die bei störungsfreiem Empfang dem ersten kennungssignalindividuellen Speicher (S1x) zugeordnet ist, dem zweiten kennungssignalindividuellen Speicher (S2x) zuordnet.

3. Verfahren nach Anspruch 1 oder 2,
**dadurch gekennzeichnet,**
daß die Steuerung (CPU) bei Auftreten von Fernsehsendersignalen ohne Kennungssignal ebenfalls je ein die Fersehsenderfrequenz- und -feldstärke bezeichnendes Informationspaar (f′yA′y, y= 1 ... m) bildet, und diese Informationspaare (f′yA′y) in 2m paarweise miteinander verknüpfte, nach ab- oder aufsteigenden Feldstärkewerten geordnete Speicherplatzpaare(MfyMAy) eines nichtkennungssignalindividuellen Speichers (My) abspeichert, dem speicherplatzpaarindividuelle Stationstasten (Ty) zugeordnet sind.

4. Verfahren nach Anspruch 2 oder 3,
**dadurch gekennzeichnet,**
daß die Steuerung (CPU), sofern bei einem Sendersuchlauf Fernsehsendersignale mit einem Kennungssignal auftreten, für die keine ersten kennungssignalindividuelle Speicher (S1x) vorgesehen sind, die entsprechenden Fernsehsenderfrequenz (fx) und Fersehsenderfeldstärke (Ax) bezeichnenden Informationspaare (f′xA′x) in den nichtkennsignalindividuellen Speicher (My) abspeichert.

5. Verfahren nach Anspruch 3 oder 4, dadurch gekennzeichnet, daß die Steuerung (CPU) die Informationspaare (f′yA′y) der Fernsehsendersignale ohne Kennungssignal und gegebenenfalls die Informationssignale (f′xA′x) der Fernsehsendersignale mit kennungssignal, für die keine ersten kennungssignalindividuellen Speicher (S1x) vorgesehen sind, in der Weise auf die Speicherplätze (MfyMAy) des nichtkennungssignalindividuellen Speichers (My) verteilt, daß in einem, einer ersten speicherplatzindividuellen Stationstaste (Ty, y=1) zugeordneten Speicherplatzpaar (Mf1MA1) das der größten Feldstärke (A1) entsprechende Informationspaar (f′1A′1) abgespeichert wird und daß in einem zweiten, einer zweiten Stationstaste (T2) zugeordneten Speicherplatzpaar (Mf2MA2) das der zweitgrößten Feldstärke (A2) entsprechende Informationspaar(f′2A′2) und in weiteren, den weiteren Stationstasten (T3...Tm) zugeordneten Speicherplatzpaaren (Mf3MA3 ...MfmMAm) diejenigen Informationspaare(f′3A′3 ...f′mA′m) abgespeichert werden, die den weiteren Feldstärken (A3...Am)in abnehmender Reihenfolge ihrer Werte entsprechen.

6. Verfahren nach Anspruch 5,
**dadurch gekennzeichnet,**
daß die Steuerung (CPU) nach der Bildung eines zeitlich ersten Frequenz- und Feldstärkeinformationspaars dieses in das dem größten Feldstärkewert(A1) zugeordneten Speicherplatzpaar (Mf1MA1) abspeichert, daß die Steuerung (CPU) nach der Bildung eines zeitlich zweiten Frequenz- und Feldstärkeinformationspaars den entsprechenden zweiten Feldstärkewert mit dem dem zeitlich ersten Informationspaar entsprechenden ersten Feldstärkewert vergleicht, und sofern der zweite Feldstärkewert gleich dem ersten Feldstärkewert oder kleiner als dieser ist, das zweite Informationspaar in das dem zweitgrößten Feldstärkewert (A2) zugeordneten Speicherplatzpaar(Mf2MA2) abspeichert, oder sofern der zweite Feldstärkewert größer als erste Feldstärkewert ist, das erste Informationspaar in das dem zweitgrößten Feldstärkewert zugeordneten Speicherplatzpaar (Mf2MA2) und das zweite Informationspaar in das dem größten Feldstärkewert(A1) zugeordneten Speicherplatzpaar (Mf1MA1) abspeichert, daß die Steuerung(CPU) nach Bildung jeweils eines zeitlich weiteren Informationspaars den jeweils entsprechenden Feldstärkewert mit den den abgespeicherten Informationspaaren entsprechenden Feldstärkewerten vergleicht und die abgespeicherten Informationspaare und das jeweils zeitlich weitere Informationspaar auf die den größten Feldstärkewerten (A1, A2, A3, ...) zugeordneten Speicherplatzpaare (Mf1MA1, Mf2MA2, Mf3MA3, ...) entsprechend der Zuordnung von Eingabetasten(T1, T2, T3, ...) und Feldstärkewerten (A1, A2, A3, ...) verteilt.

7. Verfahren nach einem der Ansprüche 4 bis 6,
**dadurch gekennzeichnet,**
daß die Steuerung(CPU) im Anschluß an die Verteilung der gebildeten Frequenz- und Feldstärkeinformationspaare(f′1A′1 ... f′mA′m) auf die Speicherplatzpaaare(Mf1MA1 ... MfnMAn) ausgelöst durch Betätigung einer Sondertaste (TS) und einer ersten speicherplatzindividuellen Taste(Ti) das in dem zugehörigen Speicherplatzpaar(MfiMAi) abgespeicherte Informationspaar(f′iA′i) in das Speicherplatzpaar(Mf1MA1) überführt, in dem ursprünglich das der größten Feldstärke(A1) zugeordnete Informationspaar(f′1A′1) abgespeichert war, dieses Informationspaar(f′1A′1) sowie die übrigen Informationspaare(f′2A′2 ... f′i-1, f′i+1 ... f′mA′m) auf die übrigen Speicherplatzpaare(Mf2MA2 ... MfmMAm) in abnehmender Reihenfolge der Feldstärkewerte verteilt.

8. Verfahren nach einem der Ansprüche 4 bis 6, **dadurch gekennzeichnet,**
die Steuerung(CPU) im Anschluß an die Verteilung der gebildeten Frequenz- und Feldstärkeinformationspaare (f′1A′1 ... f′1A′m) auf die Speicherplatzpaare(Mf1MA1 ... MfmMAm) ausgelöst durch Betätigung einer Sondertaste(TS), einer ersten speicherplatzindividuellen Eingabetaste(Ti) und einer zweiten speicherplatzindividuellen Eingabetaste(Tj) die in den zugehörigen Speicherplatzpaaren(MfiMAi, MfjMAj) abgespeicherten Informationspaare (f′iA′i, f′jA′j) miteinander vertauscht.

9. Anordnung zur Programmspeicherung in Fernsehempfangsgeräten, wobei eine Steuerung (CPU) des Fernsehempfangsgerätes (F) bei einem Sendersuchlauf über den von dem Fernsehempfangsgerät (F) empfangbaren Fernsehsender-Frequenzbereich nacheinander Fernsehsendersignale auf diese mitumfassende Kennungssignale (Programmquellensignale Kx) überprüft, ein die Fernsehsenderfrequenz (fx, x = 1...n) und Fernsehsenderfeldstärke (Ax) bezeichnendes Informationspaar (f′xA′x) bildet und dieses Informationspaar (f′xA′x) in erste kennungssignalindivduelle Speicher (S1x) einspeichert, denen je eine kennungssignalindividuelle Stationstaste (Tx) zugeordnet ist, durch deren Betätigung die Steuerung (CPU) die in dem zugehörigen Speicher (S1x) abgespeicherte Frequenzinformation (f′x) abruft und das Fernsehempfangsgerät (F) auf die der abgerufenen Frequenzinformation (f′x) entsprechenden Frequenz (fx) einstellt, wobei
die Steuerung (CPU) im Rahmen eines Sendersuchlaufs bei Auftreten eines zweiten oder weiteren Fernsehsenders mit gleichem Kennungssignal die Feldstärkewerte der betreffenden Fernsehsendersignale miteinader vergleicht
und, sofern der Feldstärkewert des hinzugekommenen Fernsehsendersignals größer als der abgespeicherte Feldstärkewert ist, das in dem ersten kennungsignalindividuellen Speicher (S1x) abgespeicherte Informationspaar mit dem dem hinzgekommenen Fernsehsendersignal - größerer Feldstärke entsprechenden Informationspaar überschreibt, und das bisher in dem ersten kennungssignalindividuellen Speicher (S1x) abgespeicherte Informationspaar in einen zweiten kennungssignalspezifischen Speicher (S2x) überträgt, oder sofern die Feldstärke des hinzugekommenen Fenrsehsignals gleich oder kleiner als der abgespeicherte Feldstärkewert ist, das dem hinzugekommenen Fernsehsignal entsprechende Informationspaar in den zweiten kennungssignalindividuellen Speicher (S2x) abspeichert, daß die Steuerung (CPU) ausgelöst durch einen, den Ausfall der Empfangsfeldstärke des gerade empfangenen Fernsehsendersignals größerer Feldstärke kennzeichnenden Befehl des Fernsehempfangsgeräts (F) auf die der in dem zweiten kennungssignalindividuellen Speicher (S2x) abgespeicherte Frequenzinformation (f′x) entsprechende Frequenz (fx) des kennungssignalgleichen Fernsehsendersignals einstellt,
**dadurch gekennzeichnet,** daß eine Fernsehempfangsgeräte-Steuerung (CPU) über einen Datenbus (DB) mit einem Betriebsprogrammspeicher (RAM) und einem Arbeitsspeicher (MEM) verbunden ist, der erste und zweite kennungssignalindividuelle Speicher (S1x, S2x, x = 1, ... n) zur Aufnahme von Fernsehsenderfrequenz (fx) und Fernsehsenderfeldstärke (Ax) bezeichnender Informationspaare (f′xA′x) sowie einen Tabellenspeicher (TSP) zur Aufnahme von Adressendaten der ersten und zweiten kennungssignalindividuellen Speicher (S1x, S2x) umfaßt, und daß die Steuerung (CPU) über den Datenbus (DB) mit Stationstasten (Tx) verbunden ist.

10. Anordnung nach Anspruch 9, dadurch gekennzeichnet, daß der Arbeitsspeicher(MEM) zusätzlich nichtkennungssignalindividuelle Speicher (My) zur Aufnahme von Fernsehsenderfrequenz und Fernsehsenderfeldstärke bezeichnender Informationspaare umfaßt, und daß die Steuerung (CPU) über den Datenbus (DB) zusätzlich mit nichtkennungssignalindividuellen Tasten (Ty) verbunden ist.

11. Anordnung nach Anspruch 10, dadurch gekennzeichnet, daß die Steurung (CPU) über den Datenbus (DB) zusätzlich mit einer Sondertaste (TS) verbunden ist.

12. Anordnung nach einem der Ansprüche 9 bis 11, dadurch gekennzeichnet, daß der Arbeitsspeicher (MEM) als nichtflüchtiger Speicher ausgebildet ist.

## Claims

1. Method of program storage in television receivers, wherein a control (CPU) of the television receiver (F) in the case of a transmission search operation over the television transmitter frequency range, which is receivable by the television receiver (F), of successive television transmitter signals checks identification signals (program source signals Kx) including these, forms an information pair (f′xA′x) denoting the television transmitter frequency (fx,x = 1 ... n) and television transmitter field strength (Ax) and stores this information pair (f′xA′x) in first stores (S1x), which are individual to identification signal and with each of which a respective station key (Tx) individual to identification signal is associated, through the actuation of which key the control (CPU) calls up the frequency formation (f′x) stored in the associated store (S1x) and sets the television receiver (F) to the frequency (fx) corresponding to the called-up frequency information (f′x), characterised thereby that the control (CPU), within the scope of a transmission search operation and on occurrence of a second or further television transmitter with the same identification signal, compares the field strength values of the television transmitter signals concerned with one another and, when the field strength value of the additional television transmitter signal is greater than the stored field strength value, the information pair stored in the first store (S1x) individual to identification signal is written over by the information pair corresponding to the additional television transmitter signal of greater field strength, and the information pair formerly stored in the first store (S1x) individual to identification signal is transferred to a second store (S2x) specific to identification signal, or when the field strength of the additional television signal is the same as or smaller than the stored field strength value the information pair corresponding to the additional television signal is stored in the second store (S2x) individual to identification signal, that the control (CPU), triggered by a command characterising the drop in the reception field strength of the just-received television transmitter signal of greater field strength, sets the television receiver (F) to the frequency (fx), which corresponds to the frequency information (f′x) stored in the second store (S2x) individual to identification signal, of the television transmitter signal equal to identification signal.

2. Method according to claim 1, characterised thereby that the control (CPU), triggered by the command characterising the drop in the reception field strength of the just-received television transmitter signal of greater field strength, assigns the station key (Tx), which in the case of interference-free reception is associated with the first store (S1x) individual to identification signal, to the second store (S2x) individual to identification signal.

3. Method according to claim 1 or 2, characterised thereby that the control (CPU), on occurrence of television transmitter signals without identification signal, similarly forms a respective information pair (f′yA′y,y=1...m) denoting the television transmitter frequency and field strnegth, and stores these information pairs (f′yA′y) in 2m storage place pairs (MfyMAy), which are interlinked in pairs and ordered according to decreasing or increasing field strength values, of a store (My) which is not individual to identification signal and with which station keys (Ty) individual to storage place pair are associated.

4. Method according to claim 2 or 3, characterised thereby that the control (CPU), when television transmission signals with an identification signal for which no first stores (S1x) individual to identification signal are provided occur in the case of a transmitter search operation, stores information pairs (f′xA′x), which denote the corresponding television transmitter frequency (fx)and television transmitter field strength (Ax), in the stores (My) not individual to identification signal.

5. Method according to claim 3 or 4, characterised thereby that the control (CPU) distributes the information pairs (f′yA′y) of the television transmitter signals without identification signal, and in a given case the information signals (f′xA′x) of the television transmitter signals with identification signal for which no first stores (S1x) individual to identification signal are provided, to the storage places (MfyMAy) of the store (My) not individual to identification signal in such a manner that the information pair (f′1A′1) corresponding to the greatest field strength (A1) is stored in a storage place pair (mf1MA1) associated with a first station key (Ty, y=1) individual to storage place and that the information pair (f′2A′2) corresponding to the second-greatest field strength (A2) is stored in a second storage place pair (Mf2MA2) associated with a second station key (T2) and that those information pairs (f′3A′3 ... f′mA′m), which correspond to the further field strengths (A3 ... Am) in decreasing sequence of their values, are stored in further storage place pairs (Mf3MA3...MfmMAm) associated with further station keys (T3...Tm).

6. Method according to claim 3, characterised thereby that the control (CPU), after formation of a frequency and field strength information pair which is first in time, stores this in the storage place pair (Mf1MA1) associated with the greatest field strength value (A1), that the control (CPU), after the formation of a frequency and field strength information pair which is second in time, compares the corresponding second field strength value with the first field strength value corresponding to the information pair first in time and, when the second field strength value is the same as the first field strength value or smaller than this, stores the second information pair in the storage place pair (Mf2MA2) associated with the second-greatest field strength value (A2) or, when the second field strength value is greater than the first field strength value, stores the first information pair in the storage place pair (Mf2MA2) associated with the second-greatest field strength value and the second information pair in the storage place pair (Mf1MA1) associated with the greatest field strength value (A1), that the control (CPU), after formation each time of an information pair further on in time, compares the respective corresponding field strength value with the field strength values corresponding to the stored formation pairs and distributes the stored information pairs and the respective information pairs further on in time to the storage place pairs (Mf1MA2, Mf2MA2, Mf3MA3, ...), which are associated with the greatest field strength values (A1, A2, A3 ...), corresponding to the association of input keys (T1, T2, T3 ...) and field strength values (A1, A2, A3, ...).

7. Method according to one of claims 4 to 6, characterised thereby that the control (CPU), subsequent to the distribution of the formed frequency and field strength information pairs (f′1A1 ... f′mA′m) to the storage place pairs (Mf1MA1 ... MfnMAn) and triggered by actuation of a special key (TS) and a first key (Ti) individual to storage place, transfers the information pair (f′iA′i), which is stored in the associated storage place pair (MfiMAi), to the storage place pair (Mf1MA1) in which originally the information pair (f′1A′1) associated with the greatest field strength (A1) was stored, and distributes this information pair (f′1A′1) as well as the remaining information pairs (f′2A′2) ... f′i-1, f′i+1, ... f′mA′m) to the remaining storage place pairs (Mf2MA2 ... MfmMAm) in decreasing sequence of the field strength values.

8. Method according to one of claims 4 to 6, characterised thereby that the control (CPU), subsequent to the distribution of the formed frequency and field strength information pairs (f′1A′1 ... f′1A′m) to the storage place pairs (Mf1MA1 ... MfmMAm) and triggered by actuation of a special key (TS), a first input key (Ti) individual to storage place and a second input key (Tⱼ) individual to storage place interchanges the information pairs (f′iA′i, f′jA′j) stored in the associated storage place pairs (MfiMAi, MfjMAj).

9. Arrangement for program storage in television receivers, wherein a control (CPU) of the television receiver (F) in the case of a transmission search operation over the television transmitter frequency range, which is receivable by the television receiver (F), of successive television transmitter signals checks identification signals (program source signals Kx) including these, forms an information pair (f′xA′x) denoting the television transmitter frequency (fx,x=1...n) and television transmitter field strength (Ax) and stores this information pair (f′xA′x) in first stores (S1x), which are individual to identification signal and with each of which a respective station key (Tx) individual to identification signal is associated, through the actuation of which key the control (CPU) calls up the frequency formation (f′x) stored in the associated store (S1x) and sets the television receiver (F) to the frequency (fx) corresponding to the called-up frequency information (f′x), wherein characterised thereby that the control (CPU), within the scope of a transmission search operation and on occurrence of a second or further television transmitter with the same identification signal, compares the field strength values of the television transmitter signals concerned with one another and, when the field strength value of the additional television transmitter signal is greater than the stored field strength value, the information pair stored in the first store (S1x) individual to identification signal is written over by the information pair corresponding to the additional television transmitter signal of greater field strength, and the information pair formerly stored in the first store (S1x) individual to identification signal is transferred to a second store (S2x) specific to identification signal, or when the field strength of the additional television signal is the same as or smaller than the stored field strength value the information pair corresponding to the additional television signal is stored in the second store (S2x) individual to identification signal, that the control (CPU), triggered by a command characterising the drop in the reception field strength of the just-received television transmitter signal of greater field strength, sets the television receiver (F) to the frequency (fx), which corresponds to the frequency information (f′x) stored in the second store (S2x) individual to identification signal, of the television transmitter signal equal to identification signal, characterised thereby that a television receiver control (CPU) is connected by way of a data bus (DB) with an operating program store (RAM) and a working store (MEM), which comprises first and second stores (S1x, S2x, x=1,...n) individual to identification signal for reception of information pairs (f′xA′x) denoting television transmitter frequency (fx) and television transmitter field strength (Ax) as well as a tabular store (TSP) for reception of address data of the first and second stores (S1x, S2x) individual to identification signal, and that the control (CPU) is connected with station keys (Tx) by way of the data bus (DB).

10. Arrangement according to claim 9, characterised thereby that the working store (MEM) comprises additional stores (My), which are not individual to identification signal, for reception of television transmitter frequency and television transmitter field strength, and that the control (CPU) is connected by way of the data bus (DB) additionally with keys (Ty) not individual to identification signal.

11. Arrangement according to claim 10, characterised thereby that the control (CPU) is connected by way of the data bus (DB) additionally with a separate key (TS).

12. Arrangement according to one of claims 9 to 11, characterised thereby that the working store (MEM) is constructed as a non-volatile store.

## Revendications

1. Procédé pour la mémorisation de programmes dans des récepteurs de télévision, selon lequel, lors d'une recherche d'émetteurs dans la gamme des fréquences d'émetteurs télévision, qui peut être reçue par le récepteur de télévision (F), contrôle successivement des signaux d'émetteurs de télévision pour déterminer si ces derniers contiennent simultanément des signaux d'identification (signaux Kx de sources de programmes), forme un couple d'informations (f′xA′x) désignant la fréquence (fx, x = 1...n) d'un émetteur de télévision et l'intensité (Ax) du champ de l'émetteur de télévision et mémorise ce couple d'informations (f′xA′x) dans des premières mémoires (S1x) prévues individuellement pour les signaux d'identification et auxquelles sont associées des touches respectives de stations (Tx), prévues individuellement pour les signaux d'identification et au moyen de l'actionnement desquelles l'unité de commande (CPU) appelle l'information de fréquence (f′x) mémorisée dans la mémoire associée (S1x) et règle le récepteur de télévision (F) sur la fréquence (fx), qui correspond à l'information de fréquence appelée (f′x), caractérisé en ce
que dans le cadre d'un cycle de recherche d'émetteurs, lors de l'apparition d'un second ou d'un autre émetteur de télévision possédant le même signal d'identification, l'unité de commande (CPU) compare entre elles les valeurs des intensités de champ des signaux considérés des émetteurs de télévision et, dans la mesure où la valeur de l'intensité de champ du signal d'émetteur de télévision arrivant en supplément est supérieure à la valeur d'intensité de champ mémorisée, enregistre le couple d'informations correspondant au signal d'émetteur de télévision arrivant en supplément et qui possède une intensité de champ supérieure, en surinscription sur le couple d'informations mémorisé dans la première mémoire (S1x) prévue individuellement pour un signal d'identification, et transmet le couple d'informations, mémorisé jusqu'alors dans la première mémoire (S1x) prévue individuellement pour le signal d'identification, dans une seconde mémoire (S2x) spécifique pour un signal d'identification, ou, dans la mesure où l'intensité de champ du signal de télévision arrivant en supplément est égale ou inférieure à la valeur de l'intensité de champ mémorisée, mémorise le couple d'informations correspondant au signal de télévision arrivant en supplément, dans la seconde mémoire (S2x) prévue individuellement pour un signal d'identification, et que, d'une manière déclenchée par une instruction caractérisant le manque de l'intensité de champ de réception du signal d'émission de télévision précisément reçu et qui possède une intensité de champ supérieure, l'unité de commande (CPU) règle le récepteur de télévision (F) sur la fréquence (fx) du signal d'émetteur de télévision possédant le même signal d'identification, qui correspond à l'information de fréquence (f′x) mémorisée dans la seconde mémoire (S2x) prévue individuellement pour un signal d'identification.

2. Procédé selon la revendication 1, caractérisé en ce que, d'une manière déclenchée par l'instruction caractérisant le manque de l'intensité de champ de réception du signal d'émetteur de télévision, précisément reçu et possédant une intensité de champ supérieure, l'unité de commande (CPU) associe la touche (Tx) de la station, qui est associée à la première mémoire (S1x) prévue individuellement pour un signal d'identification, dans le cas d'une réception sans perturbation, à la seconde mémoire (S2x) prévue individuellement pour un signal d'identification.

3. Procédé selon la revendication 1 ou 2, caractérisé en ce que lors de l'apparition de signaux d'émetteurs de télévision ne comportant pas de signal d'identification, l'unité de commande (CPU) forme également respectivement un couple d'informations (f′yA′y, y = 1...m) désignant la fréquence et l'intensité de champ de l'émetteur de télévision, et mémorise ces couples d'informations (f′yA′y) dans 2m couples (MfyMAy), combinés entre eux par couples et rangés selon des valeurs décroissantes ou croissantes de l'intensité de champ d'une mémoire (My) prévue individuellement pour un signal de non identification et à laquelle sont associées des touches de stations (Ty) prévues individuellement pour des couples d'emplacements de mémoire.

4. Procédé selon la revendication 2 ou 3, caractérisé en ce que, dans la mesure où lors d'un cycle de recherche d'émetteurs il apparaît des signaux d'émetteurs de télévision comportant un signal d'identification et pour lesquels n'est prévue aucun première mémoire (S1x) prévue individuellement pour un signal d'identification, l'unité de commande (CPU) mémorise les couples correspondant d'informations (f′xA′x) qui désignent la fréquence (fx) de l'émetteur et l'intensité de champ (Ax) de l'émetteur de télévision, dans la mémoire (My) prévue individuellement pour un signal de non identification.

5. Procédé selon la revendication 3 ou 4, caractérisé en ce que l'unité de commande (CPU) répartit les couples d'informations (f′yA′y) des signaux d'émetteurs de télévision sans signal d'identification et éventuellement les signaux d'informations (f′xA′x) des signaux d'émetteurs de télévision comportant un signal d'identification et pour lesquels il n'est prévue aucune première mémoire (S1x) prévue individuellement pour un signal d'identification, entre les emplacements (Mf′MAy) de la mémoire (My) prévue individuellement pour un signal de non identification, de telle sorte que le couple d'informations (f′1A′1), qui correspond à l'intensité de champ maximale (A1), est mémorisé dans un premier couple d'emplacements de mémoire (Mf1MA1), associé à une première touche de station (Ty, y = 1) prévue individuellement pour un emplacement de mémoire, et que le couple d'informations (f′2A′2), qui correspond à l'intensité de champ la plus élevée en second (A2), est mémorisé dans un second couple d'emplacements de mémoire (Mf2MA2) associé à une seconde touche de station (T2), et que des couples d'informations (f′3A′3...f′mA′m), qui correspondent, du point de vue de la succession décroissante de leurs valeurs, aux autres intensités de champ (A3...Am), sont mémorisés en d'autres couples d'emplacements de mémoire (Mf3MA3...MfmMAm), qui sont associés aux autres touches de stations (T3...Tm).

6. Procédé selon la revendication 5, caractérisé en ce qu'après formation d'un premier couple, dans le temps, d'informations de fréquence et d'intensité de champ, l'unité de commande (CPU) mémorise ce couple d'informations dans le couple d'emplacements de mémoire (Mf1MA1) associé à la valeur maximale d'intensité de champ (A1), qu'après formation d'un second couple, dans le temps, d'informations de fréquence et d'intensité de champ, l'unité de commande (CPU) compare la seconde valeur d'intensité de champ correspondante à la première valeur d'intensité de champ, qui correspond au premier couple d'informations, dans le temps, et, dans la mesure où la seconde valeur d'intensité de champ est égale ou inférieure à la première valeur d'intensité de champ, le second couple d'informations, mémorisé dans le couple d'emplacements de mémoire (Mf2MA2) associé à la valeur d'intensité de champ maximale en second (A2), ou, dans la mesure où la seconde valeur d'intensité de champ est supérieure à la première valeur d'intensité de champ, le premier couple d'informations est mémorisé dans le couple d'emplacements de mémoire (Mf2MA2) associé à la valeur d'intensité de champ maximale en second et que le second couple d'informations est mémorisé dans le couple d'emplacements de mémoire (Mf1MA1) associé à la valeur de l'intensité de champ maximale (A1), qu'après formation respectivement d'un couple d'informations ultérieur, l'unité de commande (CPU) compare la valeur d'intensité de champ respective correspondante aux valeurs d'intensité de champ correspondant aux couples d'informations mémorisés et répartit les couples d'informations mémorisés et le couple d'informations respectivement ultérieur, entre les couples d'emplacements de mémoire (Mf1MA1, Mf2MA2, Mf3MA3, ...), qui sont associés aux valeurs d'intensité de champ maximales (A1,A2,A3,...), en fonction de l'association de touches d'entrée (T1,T2,T3, ...) et de valeurs d'intensité de champ (A1,A2,A3,...).

7. Procédé selon l'une des revendications 4 à 6, caractérisé en ce qu'à la suite de la répartition des couples formés d'informations de fréquence et d'intensité de champ (f′1A′1...f′mA′m) entre les couples d'emplacements de mémoire (Mf1MA1...MfnMAn), l'unité de commande (CPU) exécute, d'une manière déclenchée par l'actionnement d'une touche particulière (TS) et d'une première touche (Ti) prévue individuellement pour l'emplacement de mémoire, le transfert du couple d'informations (f′iA′i), mémorisé dans le couple associé d'emplacements de mémoire (MfiMAi), dans le couple d'emplacements de mémoire (Mf1MA1), dans lequel était mémorisé initialement le couple d'informations (f′1A′1) associé à l'intensité de champ maximale (A), et répartit ce couple d'informations (f′1A′1) ainsi que les autres couples d'informations (f′2A′2...f′i-1, f′i+1... f′mA′m) entre les autres couples d'emplacements de mémoire (Mf2MA2...MfmMAm), selon une séquence décroissante des valeurs de l'intensité de champ.

8. Procédé selon l'une des revendications 4 à 6, caractérisé en ce qu'à la suite de la répartition des couples formés d'informations de fréquence et d'intensité de champ (f′A′1...f′A′m) entre les couples d'emplacements de mémoire (Mf1MA1...MfmMAm), l'unité de commande (CPU) exécute, d'une manière déclenchée par l'actionnement d'une touche particulière (TS), d'une première touche d'entrée (Ti) prévue individuellement pour l'emplacement de mémoire et d'une seconde touche d'entrée (Tj) prévue individuellement pour un emplacement de mémoire, la permutation réciproque des couples d'informations (f′iA′i, f′jA′j) mémorisés dans les couples associés d'emplacements de mémoire (MfiMAi, MfjMAj).

9. Dispositif pour la mémorisation de programmes dans des récepteurs de télévision, selon lequel, lors d'une recherche d'émetteurs dans la gamme des fréquences d'émetteurs télévision, qui peut être reçue par le récepteur de télévision (F), contrôle successivement des signaux d'émetteurs de télévision pour déterminer si ces derniers contiennent simultanément des signaux d'identification (signaux Kx de sources de programmes), forme un couple d'informations (f′xA′x) désignant la fréquence (fx, x = 1...n) et l'intensité (Ax) de champ d'un émetteur de télévision et mémorise ce couple d'informations (f′xA′x) dans des premières mémoires (S1x) prévues individuellement pour les signaux d'identification et auxquelles sont associées des touches respectives de stations (Tx), prévues individuellement pour les signaux d'identification et au moyen de l'actionnement desquelles l'unité de commande (CPU) appelle l'information de fréquence (f′x) mémorisée dans la mémoire associée (S1x) et règle le récepteur de télévision (F) sur la fréquence (fx), qui correspond à l'information de fréquence appelée (f′x),
et selon lequel
dans le cadre d'un cycle de recherche d'émetteurs, lors de l'apparition d'un second ou d'un autre émetteur de télévision possédant le même signal d'identification, l'unité de commande (CPU) compare entre elles les valeurs des intensités de champ des signaux considérés des émetteurs de télévision et, dans la mesure où la valeur de l'intensité de champ du signal d'émetteur de télévision arrivant en supplément est supérieure à la valeur d'intensité de champ mémorisée, enregistre le couple d'informations correspondant au signal d'émetteur de télévision arrivant en supplément et qui possède une intensité de champ supérieure, en surinscription sur le couple d'informations mémorisé dans la première mémoire (S1x) prévue individuellement pour un signal d'identification, et transmet le couple d'informations, mémorisé jusqu'alors dans la première mémoire (S1x) prévue individuellement pour un signal d'identification, dans une seconde mémoire (S2x) spécifique pour le signal d'identification, ou, dans la mesure où l'intensité de champ du signal de télévision arrivant en supplément est égale ou inférieure à la valeur de l'intensité de champ mémorisée, mémorise le couple d'informations correspondant au signal de télévision arrivant en supplément, dans la seconde mémoire (S2x) prévue individuellement pour un signal d'identification, et, d'une manière déclenchée par une instruction caractérisant le manque de l'intensité de champ de réception du signal d'émission de télévision précisément reçu et qui possède une intensité de champ supérieure, l'unité de commande (CPU) règle le récepteur de télévision (F) sur la fréquence (fx) du signal d'émetteur de télévision possédant le même signal d'identification, qui correspond à l'information de fréquence (f′x) mémorisée dans la seconde mémoire (S2x) prévue individuellement pour un signal d'identification, caractérisé en ce qu'une unité de commande (CPU) de récepteurs de télévision est reliée par l'intermédiaire d'un bus de transmission de données (DB) à une mémoire de programme de service (RAM) et à une mémoire de travail (MEM), qui comprend des première et seconde mémoires (S1x, S2x, x = 1, ..., n) prévues individuellement pour le signal d'identification, pour la réception de couples d'informations (f′xA′x), qui désignent la fréquence (fx) de l'intensité de champ (Ax) d'un émetteur de télévision, ainsi qu'une mémoire tableau (TSP) pour la réception de données d'adresses des première et seconde mémoires (S1x, S2x) prévues individuellement pour les signaux d'identification, et que l'unité de commande (CPU) est reliée aux touches de stations (Tx) par l'intermédiaire du bus de transmission de données (DB).

10. Dispositif selon la revendication 9, caractérisé en ce que la mémoire de travail (MEM) comprend en outre des mémoires (My) prévues individuellement pour des signaux de non identification pour la réception de couples d'informations désignant la fréquence et l'intensité de champ d'émetteurs de télévision, et que l'unité de commande (CPU) est reliée en outre, par l'intermédiaire du bus de transmission de données (DB), à des touches (Ty) prévues individuellement pour des signaux de non identification.

11. Dispositif selon la revendication 10, caractérisé en ce que l'unité de commande (CPU) est reliée en supplément par l'intermédiaire du bus de transmission de données (DB) à une touche particulière (TS).

12. Dispositif selon l'une des revendications 9 à 11, caractérisé en ce que la mémoire de travail (MEM) est agencée sous la forme d'une mémoire non volatile.
